# EUROPEAN PATENT SPECIFICATION

(11) **EP 2 348 803 B1**
(45) Date of publication and mention of the grant of the patent: **26.02.2014**
(21) Application number: 10193934.6
(22) Date of filing: 07.12.2010
(51) Int. Cl.: H05K 7/14, H05K 7/20

(54) **Container-type data center**
Containerartiges Datenzentrum
Centre de données de type conteneur

(30) Priority: 20.01.2010 CN 201010042876
(43) Date of publication of application: 27.07.2011
(60) Divisional application: 13188209.4
(73) Proprietor: Huawei Technologies Co., Ltd., Longgang District, Shenzhen Guangdong 518129 (CN)
(72) Inventor: Zhao, Jun, 518129, Shenzhen Guangdong (CN); Zhuang, Zhenyu, 518129, Shenzhen Guangdong (CN); Hu, Hangkong, 518129, Shenzhen Guangdong (CN); Hao, Mingliang, 518129, Shenzhen Guangdong (CN); Peng, Yonghui, 518129, Shenzhen Guangdong (CN); Zhang, Wei, 518129, Shenzhen Guangdong (CN); Wei, Na, 518129, Shenzhen Guangdong (CN); Xu, Shihui, 518129, Shenzhen Guangdong (CN)
(74) Representative: Kreuz, Georg Maria

(56) References cited:
- EP-A2- 2 101 017
- WO-A1-2007/054578
- WO-A1-2007/082351
- US-A1- 2007 135 032
- US-A1- 2008 285 232
- US-A1- 2009 241 578

## Description

### FIELD OF THE TECHNOLOGY

The present invention relates to the field of communication technology, and more particularly to a container-type data center.

### BACKGROUND OF THE INVENTION

Being a mini-type data center solution having a low cost, high integration level, high efficiency, high flexibility, and quick deployment, a movable container-type data center is increasingly adopted by various manufacturers. In order to solve a layout problem of the container-type data center under requests of high density and small maintenance space, different manufacturers propose different layout or maintenance solutions.

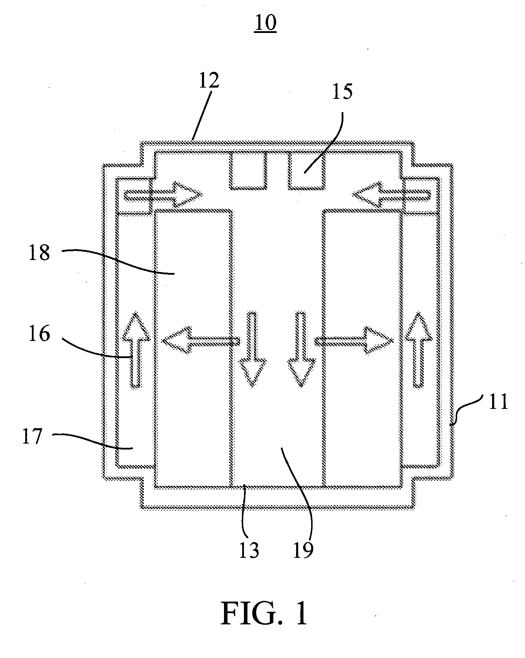

A container-type data center 10 of the prior art is as shown in FIG. 1. The container-type data center 10 includes a container, and the container includes two side walls 11, and a top wall 12 and a bottom plate 13 connected to the two side walls 11. The container has two rows of cabinets 18 8 disposed therein, and the cabinets of each row are respectively close to the two side walls 11 and are spaced by a certain distance. The cabinets 18 are face-to-face disposed, and each cabinet 18 is arranged perpendicular to the side wall 11 of the container. The container-type data center 10 further includes a refrigerating unit 15, disposed on the top wall 12 of the container. An air outlet channel 17 is formed between two rows of the cabinets and the side wall 11 of the container. A maintenance channel is formed between the two rows of the cabinets, so as to form an air inlet channel 19. A flowing direction 16 of an air flow in the entire container is as shown in FIG. 1. Hot air generated by devices in the cabinets 18 is exhausted to the air outlet channel 17, cooled by the refrigerating unit 15 disposed on the top wall 12, and then supplied back to the air inlet channel 19 through a fan.

During the procedure of implementing the present invention, the inventors find that the prior art at least has the following problems.

In the prior art, the container is a standard container with a fixed width size. Due to the arrangement of the two rows of the cabinets, the width of the cabinet placed in the container is limited to the width of the container, that is, only the cabinet with certain width size can be placed, such that when the width size of the container is fixed, a cabinet with a large size cannot be integrated, so the integration level of the data center is not high.

WO patent application 2007/082351 A1 relates to an apparatus for providing data processing capabilities.

US patent application 2009/241578 A1 relates to a data center cooling system includes a floor structure defining a below-floor warm-air plenum and an above-floor cool air plenum, a plurality of above-floor computer assemblies arranged to exhaust warmed air into the warm-air plenum.

EP patent application 2101017 A2 relates to a portable modular data center comprising one or more modular containers forming a modular containment structure which provide practical and efficient mobility as the data center can be quickly deployed at a remote site or location.

WO patent application 2007/054578 A1 relates to a cooling system for a room containing electronic data processing equipment comprises a raised floor construction dividing the room into a plenum space underneath the raised floor and a usable space above the raised floor, an air conditioning device for feeding cooled air to the plenum space and a cooling module.

### SUMMARY OF THE INVENTION

The present invention is directed to a container-type data center, capable of improving an integration level of the data center.

In an embodiment, the present invention provides a container-type data center, which includes a container, at least three rows of cabinets, and data processing devices. The data processing devices are disposed in the cabinets. The at least three rows of the cabinets are disposed in parallel and perpendicular to a long edge of the container. Two neighboring rows of the cabinets of the at least three rows of the cabinets are back-against-back disposed or disposed at intervals, in which when the two neighboring rows of the cabinets are disposed at intervals, a maintenance channel is formed from the space between the two neighboring rows of the cabinets; two ends of the maintenance channel are the long edge of the container, and an openable or removable partition door is opened on the long edge of one end or two ends.

As the at least three rows of the cabinets are disposed in parallel and perpendicular to the long edge of the container, the cabinets of each row are not limited to a width of the container in a width direction, and a cabinet with a large size can be integrated, thereby improving an integration level of the container.

### BRIEF DESCRIPTION OF THE DRAWINGS

To illustrate the technical solutions according to the embodiments of the present invention more clearly, the accompanying figures for describing the embodiments or the prior art are introduced briefly in the following.
FIG. 1 is a schematic side structural view of a container-type data center in the prior art;
FIG. 2(a) is a schematic top structural view of a container-type data center;
FIG. 2(b) is a schematic top structural view of another container-type data center;
FIG. 3 is a schematic top structural view of a container-type data center;
FIG. 4 is a schematic top structural view of a container-type data center;
FIG. 5 is a schematic top structural view of a container-type data center;
FIG. 6 is a schematic top structural view of a container-type data center;
FIG. 7 is a schematic top structural view of a container-type data center;
FIG. 8 is a schematic top structural view of a container-type data center;
FIG. 9 is a schematic top structural view of a container-type data center according to a first embodiment of the present invention;
FIG. 10 is a schematic top structural view of a container-type data center according to a second embodiment of the present invention; and
FIG. 11 is a schematic top structural view of a container-type data center according to a third embodiment of the present invention.

### DETAILED DESCRIPTION OF THE EMBODIMENTS

In order to make the objectives, technical solutions, and advantages of the present invention more comprehensible, a detailed description of the present invention is given below by reference to the embodiments and the accompanying drawings. It should be understood that the embodiments are only intended to explain the present invention instead of limiting the scope of the present invention.

The embodiment of the present invention provides a container-type data center, which includes a container, at least three rows of cabinets, and data processing devices. The data processing devices are disposed in the cabinets. The at least three rows of the cabinets are disposed in parallel and perpendicular to a long edge of the container. Two neighboring rows of the cabinets of the at least three rows of the cabinets are back-against-back disposed or disposed at intervals, in which for each of the two neighboring rows of the cabinets disposed at intervals, a maintenance channel is formed from the space between the two neighboring rows of the cabinets.

In the embodiment of the present invention, as the at least three rows of the cabinets are disposed in parallel and perpendicular to the long edge of the container, each row of the cabinets is not limited to a width of the container in a width direction, and a cabinet with a large size can be integrated, thereby improving an integration level of the container.

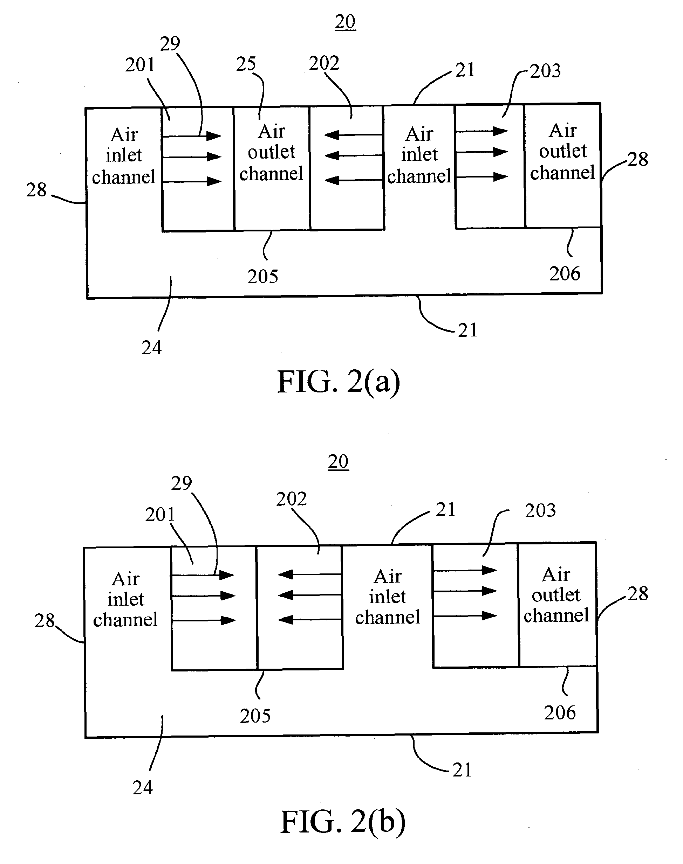

FIG. 2(a) is a schematic top structural view of an example of a container-type data center 20. The container-type data center of the present invention includes at least three rows of the cabinets, but FIG. 2(a) only shows three rows of the cabinets for ease of illustration. The container-type data center 20 includes a container and at least three rows of the cabinets. The at least three rows of the cabinets are disposed in parallel and perpendicular to a long edge 21 of the container, that is, two long side walls of the container. As the at least three rows of the cabinets are disposed in parallel and perpendicular to the long edge 21 of the container, the cabinets of two neighboring rows of the at least three rows of the cabinets are back-against-back disposed or disposed at intervals, in which when the cabinets of the two neighboring rows are disposed at intervals, a maintenance channel is formed from the space between the two neighboring rows of the cabinets. The cabinets of the two neighboring rows of the at least three rows of the cabinets may be partially back-against-back disposed, partially disposed at intervals, or are all disposed at intervals. The manner that the two neighboring rows of the cabinets are disposed at intervals includes back-to-back or face-to-face disposition, an air inlet channel is formed from the space between the two neighboring rows of the cabinets being face-to-face disposed, and an air outlet channel is formed from the space between the two neighboring rows of the cabinets being back-to-back disposed. The two neighboring rows of the cabinets being back-against-back disposed are front maintenance cabinets.

If only three rows of the cabinets are taken as an example for illustration, as shown in FIG. 2(a), the three rows of the cabinets are respectively a first row of the cabinets 201, a second row of the cabinets 202, and a third row of the cabinets 203. The cabinets of the three rows are disposed at intervals, specifically, the first row of the cabinets 201 and the second row of the cabinets 202 are back-to-back disposed, and the third row of the cabinets 203 and the second row of the cabinets 202 are face-to-face disposed. An air outlet channel 25 is formed from the space between the first row of the cabinets 201 and the second row of the cabinets 202, an air inlet channel 21 is formed from the space between the third row of the cabinets 203 and the second row of the cabinets 202, the air inlet channel is isolated from the air outlet channel in the container, and a maintenance channel 24 is formed from the space among the three rows of the cabinets. In the example, the three rows of the cabinets are all disposed near a long edge of the container, that is, the three rows of the cabinets are disposed along a straight line.

It may be known from FIG. 2(a) that in addition to forming the air outlet channel 25 at intervals between the first row of the cabinets 201 and the second row of the cabinets 202, an air outlet channel is formed between the third row of the cabinets 203 and a container end door 28 near the third row of the cabinets 203; and in addition to forming the air inlet channel at intervals between the third row of the cabinets 203 and the second row of the cabinets 202, an air inlet channel is formed between the first row of the cabinets 201 and a container end door 28 near the first row of the cabinets 201. The cabinet air passage is down-in and up-out, front-in and front-out, or down-in and down-out.

The data center further includes a refrigerating unit (not shown). The refrigerating unit includes an exchanger and a fan, and may be disposed on a top portion, a side portion, or a lower portion of each row of the cabinets, or may be disposed at intervals between the two neighboring rows of the cabinets. Taking the first row of the cabinets 201 as an example, if the refrigerating unit is disposed on the top portion of the first row of the cabinets 201, hot air (the air flow is indicated by a numeral 29 in FIG. 2) generated by devices in the first row of the cabinets 201 is exhausted to the air outlet channel 25 formed from the space between the first row of the cabinets 201 and the second row of the cabinets 202, cooled by the exchanger in the refrigerating unit, and then supplied to the air inlet channel of the first row of the cabinets 201 through the fan; (cf. FIG.1).

A partition door configured to isolate the channel from the outside is disposed on an end portion of the air outlet channel and/or the air inlet channel. As shown in FIG. 2(a), a first partition door 205 is disposed between the first row of the cabinets 201 and the second row of the cabinets 202, so as to isolate the air outlet channel 25 from the outside, where the air outlet channel 25 is formed from the space between the first row of the cabinets 201 and the second row of the cabinets 202; and a second partition door 206 is disposed between the third row of the cabinets 203 and the container end door 28 near the third row of the cabinets 203, so as to isolate the air outlet channel from the outside, where the air outlet channel is formed from the space between the third row of the cabinets 203 and the container end door near the third row of the cabinets 203. Through the first partition door 205 and the second partition door 206, the air outlet channels formed in the container, that is, the air outlet channel between the first row of the cabinets 201 and the second row of the cabinets 202 and the air outlet channel between the third row of the cabinets 203 and the container end door 28 near the third row of the cabinets 203, are isolated from the air inlet channels formed in the container, that is, the air inlet channel formed from the space between the third row of the cabinets 203 and the second row of the cabinets 202 and the air inlet channel between the first row of the cabinets 201 and the container end door 28 near the first row of the cabinets 201.

In the example, as the three rows of the cabinets are disposed in parallel and perpendicular to the long edge of the container, each row of the cabinets is not limited to a width of the container in a width direction, and a cabinet with a large size can be integrated, thereby improving an integration level of the container.

A maintenance channel 24 is formed between the other long edge of the container and the three rows of the cabinets, for allowing a maintainer to perform device maintenance. The container further includes two container end doors 28, and it can be understood that one or two of the container end doors 28 may be opened, and the maintainer may enter the container to perform device maintenance after opening the container end door 28.

All of the cabinets as shown in FIG. 2(a) are disposed at intervals, or the two neighboring rows of the cabinets are partially back-against-back disposed, and partially disposed at intervals. As shown in FIG. 2(b), the first row of the cabinets 201 and the second row of the cabinets 202 are back-against-back disposed, and the third row of the cabinets 203 and the second row of the cabinets 202 are face-to-face disposed.

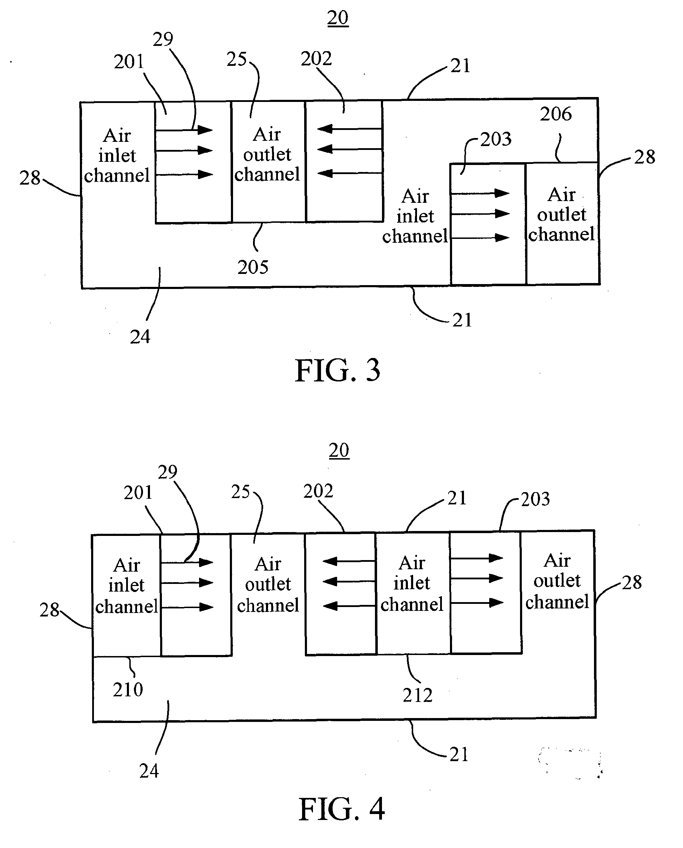

FIG. 3 is a schematic top structural view of an example of a container-type data center. The structure of this example is similar to the structure of the first example, except that the first row of the cabinets 201 and the second row of the cabinets 202 are disposed near one long edge of the container, and the third row of the cabinets 203 is disposed near the other long edge of the container. Through the disposition, the three rows of the cabinets are prevented from being gathered on one side of the container. If the three rows of the cabinets are gathered on one side of the container, the center of gravity of the container is unstable, causing inconvenience during the transportation process. In addition, during the use of the data center, if all the cabinets are gathered on one side of the container, a bottom plate of the container or the foundation may be damaged, thereby reducing the service life of the container.

FIG. 4 is a schematic top structural view of an example of a container-type data center. The structure of this example is similar to the structure of the first example, except that the air outlet channels in the container are isolated from the air inlet channels of the outside through the first partition door 205 and the second partition door, and the air inlet channels in the container are isolated from the air outlet channels of the outside through the partition door. Specifically, as shown in FIG. 4, in the example, a third partition door 210 is disposed between the first row of the cabinets 201 and the container end door 28 near the first row of the cabinets 201, so as to isolate the air inlet channel from the outside, where the air inlet channel is formed from the space between the first row of the cabinets 201 and the container end door 28 near the first row of the cabinets 201; and a fourth partition door 212 is disposed between the second row of the cabinets 202 and the third row of the cabinets 203, so as to isolate the air inlet channel from the outside, where the air inlet channel is formed from the space between the second row of the cabinets 202 and the third row of the cabinets 203. In the example, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

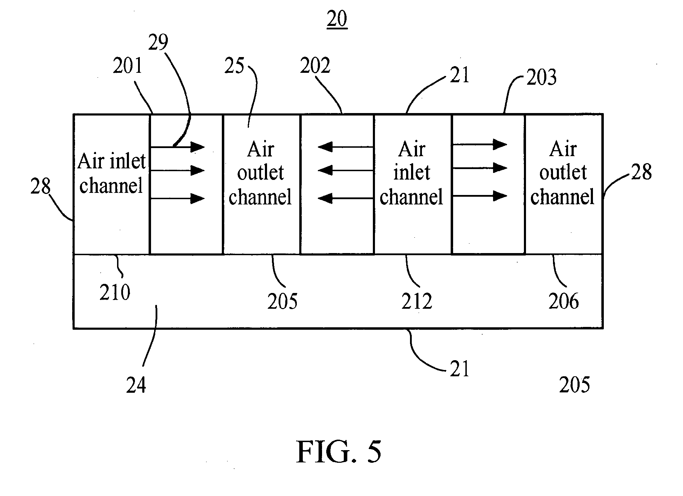

FIG. 5 is a schematic top structural view of an example of a container-type data center. The structure of this example is similar to the structure of the first example, except that in addition to disposing a first partition door 205 between the first row of the cabinets 201 and the second row of the cabinets 202, and disposing a second partition door 206 between the third row of the cabinets 203 and the container end door 28 near the third row of the cabinets 203, a third partition door 210 is disposed between the first row of the cabinets 201 and the container end door 28 near the first row of the cabinets 201, and a fourth partition door 212 is disposed between the second row of the cabinets 202 and the third row of the cabinets 203, such that the air inlet channels are isolated from the air outlet channels in the container. In the example, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

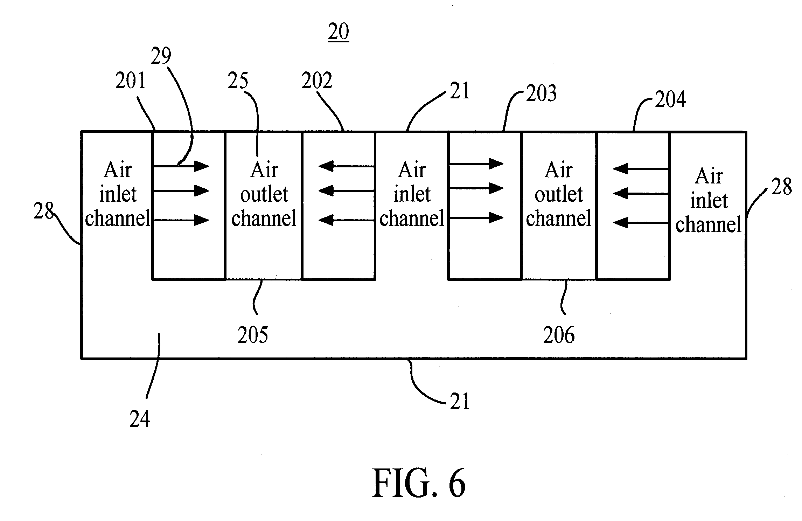

FIG. 6 is a schematic top structural view of an example of a container-type data center. The structure of this example is similar to the structure of the first example, except that the container-type data center further includes a fourth row of the cabinets 204, which are back-to-back disposed with the third row of the cabinets 203. Thus, an air outlet channel is formed from the space between the third row of the cabinets 203 and the fourth row of the cabinets 204, and an air outlet channel is formed from the space between the first row of the cabinets 201 and the second row of the cabinets 202, such that the container only has two air outlet channels. In the container, an air inlet channel is formed from the space between the second row of the cabinets 202 and the third row of the cabinets 203, an air inlet channel is formed from the space between the first row of the cabinets 201 and the container end door 28, and an air inlet channel is formed from the space between the fourth row of the cabinets 204 and the container end door 28. In the example, a first partition door 205 is disposed between the first row of the cabinets 201 and the second row of the cabinets 202, and a second partition door 206 is disposed between the third row of the cabinets 203 and the fourth row of the cabinets 204, so that the air inlet channels are isolated from the air outlet channels in the container. In the example, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

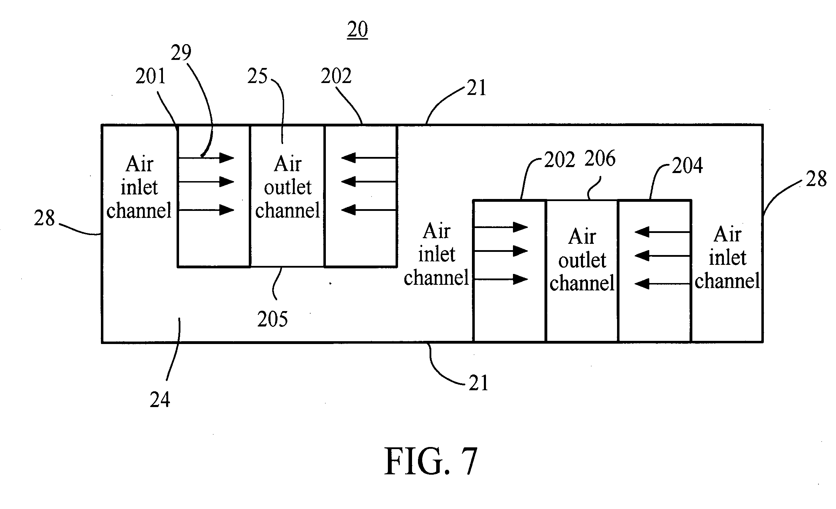

FIG. 7 is a schematic top structural view of an example of a container-type data center. The structure of this example is similar to the structure of the second example (FIG. 3), except that the container-type data center further includes a fourth row of the cabinets 204, which are back-to-back disposed with the third row of the cabinets 203. Thus, an air outlet channel is formed from the space between the third row of the cabinets 203 and the fourth row of the cabinets 204. The first row of the cabinets 201 and the second row of the cabinets 202 are disposed near one long edge of the container, and the third row of the cabinets 203 and the fourth row of the cabinets 204 are disposed near the other long edge of the container.

In the example, a first partition door 205 is disposed between the first row of the cabinets 201 and the second row of the cabinets 202, and a second partition door 206 is disposed between the third row of the cabinets 203 and the fourth row of the cabinets 204, such that the air inlet channels are isolated from the air outlet channels in the container. In the example, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

In addition, the third row of the cabinets 203 and the fourth row of the cabinets 204 are staggered from the first row of the cabinets 201 and the second row of the cabinets 202 so as to prevent the four rows of the cabinets from being gathered on one side of the container. If the four rows of the cabinets are gathered on one side of the container, the center of gravity of the container is unstable, causing inconvenience during the transportation process. In addition, during the use of the data center, if all the cabinets are gathered on one side of the container, a bottom plate of the container or the foundation may be damaged, thereby reducing the service life of the container.

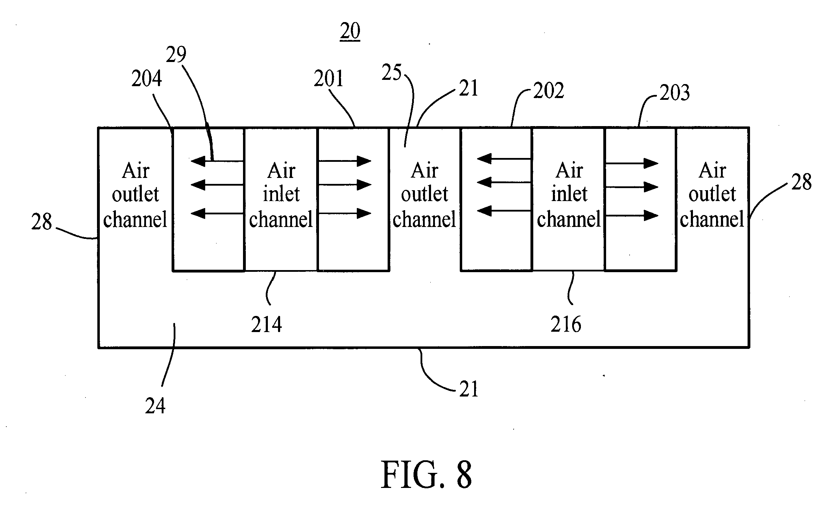

FIG. 8 is a schematic top structural view of an example of a container-type data center. The structure of this example is similar to the structure of the first example, except that the container-type data center further includes a fourth row of the cabinets 204, which are face-to-face disposed with the first row of the cabinets 201. Thus, an air inlet channel is formed from the space between the first row of the cabinets 201 and the fourth row of the cabinets 204, and an air inlet channel is formed from the space between the second row of the cabinets 202 and the third row of the cabinets 203, so that the container only has two air inlet channels. In the container, an air outlet channel is formed from the space between the first row of the cabinets 201 and the second row of the cabinets 202, an air outlet channel is formed from the space between the third row of the cabinets 203 and the container end door 28, and an air outlet channel is formed from the space between the fourth row of the cabinets 204 and the container end door 28. In the example, a first partition door 214 is disposed between the first row of the cabinets 201 and the fourth row of the cabinets 204, and a second partition door 216 is disposed between the second row of the cabinets 202 and the third row of the cabinets 203, so that the air inlet channels are isolated from the air outlet channels in the container. In the example, as the at least three rows of the cabinets are disposed in parallel and perpendicular to the long edge of the container, the cabinets of each row are not limited to a width of the container in a width direction, and a cabinet with a large size can be integrated, thereby improving an integration level of the container. It can be understood that the first partition door may also be disposed between the first row of the cabinets 201 and the second row of the cabinets 202, and the second partition doors are respectively disposed between the third row of the cabinets 203 and the container end door 28 and between the fourth row of the cabinets 204 and the container end door 28, so as to seal the air outlet channels, such that the air inlet channels are isolated from the air outlet channels in the container through a simple structure.

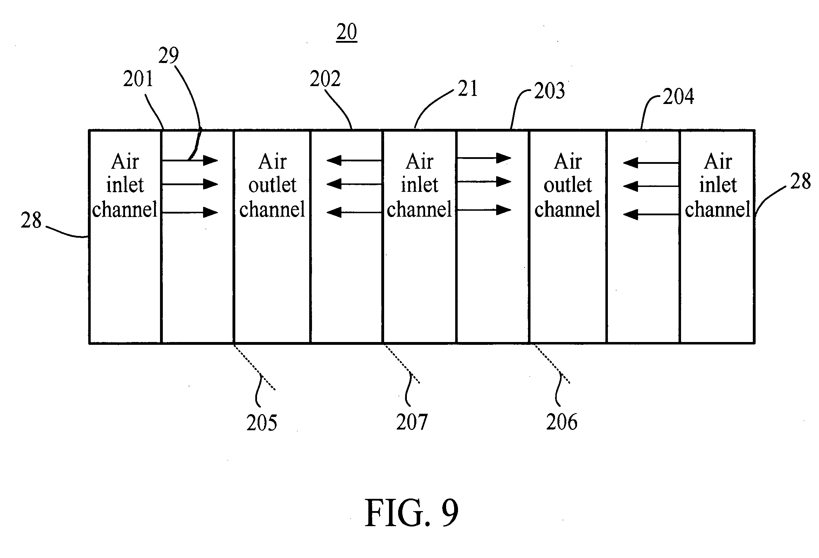

FIG. 9 is a schematic top structural view of a container-type data center according to a first embodiment of the present invention. The container-type data center includes a container and at least three rows of cabinets. The at least three rows of the cabinets are disposed in parallel and perpendicular to a long edge 21 of the container, that is, two long side walls of the container. The at least three rows of the cabinets include a first row of the cabinets 201, a second row of the cabinets 202, and a third row of the cabinets 203. The first row of the cabinets 201 and the second row of the cabinets 202 are back-to-back disposed, and the third row of the cabinets 203 and the second row of the cabinets 202 are face-to-face disposed. An air outlet channel 25 is formed from the space between the first row of the cabinets 201 and the second row of the cabinets 202, an air inlet channel is formed from the space between the third row of the cabinets 203 and the second row of the cabinets 202, and the air inlet channel is isolated from the air outlet channel in the container. The at least three rows of the cabinets are arranged from one long edge of the container to the other long edge, that is, the structure of this embodiment is different from the structure of the container-type data center according to the fifth example (FIG. 6) in that, the cabinets are also disposed on the maintenance channel 24, such that the space of the container is fully utilized, the number of the arranged cabinets is increased, and during expansion, it is not necessary to add the containers or occupy additional sites, thereby saving the construction cost of the data center.

In an embodiment, a closed space is formed between the first row of the cabinets 201 and the second row of the cabinets 202 and between the two long side walls of the container, so as to isolate the air outlet channel 25 from the outside, where the air outlet channel 25 is formed from the space between the first row of the cabinets 201 and the second row of the cabinets 202; and a closed spaced is formed between the third row of the cabinets 203 and the container end door 28 near the third row of the cabinets 203, so as to isolate the air outlet channel from the outside, where the air outlet channel is formed from the space between the third row of the cabinets 203 and the container end door 28 near the third row of the cabinets 203, so that the air inlet channel is isolated from the air outlet channel in the container. In the embodiment of the present invention, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

Two ends of the maintenance channel are the long edge of the container, and an openable and/or removable partition door is disposed on the long edge of one end or two ends. Specifically, an openable first partition door is opened on a long edge 21 between the first row of the cabinets 201 and the second row of the cabinets 202, and an openable second partition door is opened on the long edge 21 between the third row of the cabinets 203 and the container end door 28 near the third row of the cabinets 203. The maintainer may enter the air outlet channel to perform device maintenance through the first partition door and the second partition door.

In another embodiment, the container-type data center further includes a fourth row of the cabinets 204. As shown in FIG. 9, the fourth row of the cabinets 204 and the third row of the cabinets 203 are back-to-back disposed, and side walls of two ends of the fourth row of the cabinets 204 are near the two long edges of the container. A closed space is formed between the first row of the cabinets 201 and the second row of the cabinets 202 and between the two long side walls of the container, so as to isolate the air outlet channel 25 from the outside, where the air outlet channel 25 is formed from the space between the first row of the cabinets 201 and the second row of the cabinets 202; and a closed spaced is formed between the third row of the cabinets 203 and the fourth row of the cabinets 204, so as to isolate the air outlet channel from the outside, where the air outlet channel is formed from the space between the third row of the cabinets 203 and the fourth row of the cabinets 204, so that the air inlet channel is isolated from the air outlet channel in the container. In the embodiment of the present invention, as the at least three rows of the cabinets are disposed in parallel and perpendicular to the long edge of the container, the cabinets of each row are not limited to a width of the container in a width direction, and a cabinet with a large size can be integrated, thereby improving an integration level of the container.

In addition, an openable first partition door 205 is opened on a long edge 21 between the first row of the cabinets 201 and the second row of the cabinets 202, an openable second partition door 206 is opened on a long edge 21 between the third row of the cabinets 203 and the fourth row of the cabinets 204, and an openable third partition door 207 is opened on a long edge 21 between the second row of the cabinets 202 and the third row of the cabinets 203, so that the maintainer may enter the air outlet channel and the air inlet channel to perform device maintenance through the first partition door 205, the second partition door 206, and the third partition door 207. As shown in FIG. 9, dashed lines denote states that the partition doors (205, 206, and 207) are opened, and solid lines denote states that the partition doors (205, 206, and 207) are closed.

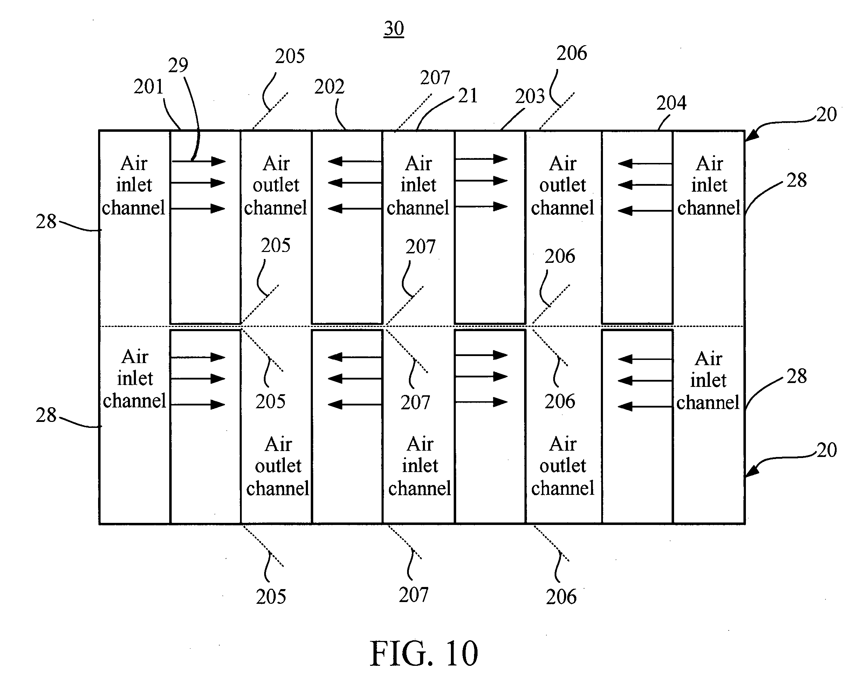

FIG. 10 is a schematic top structural view of a container-type data center cluster according to a second embodiment of the present invention. The container-type data center cluster is assembled by a plurality of container-type data centers 20 as shown in FIG. 9. The maintenance channels of the container-type data centers are butt-jointed, or the air outlet channels of the container-type data centers are butt-jointed, and the air inlet channels of the container-type data centers are butt-jointed. Only two container-type data centers 20 are shown, which may be used when a large-scale data center is constructed. The container-type data center 20 in the embodiment of the present invention is similar to the structure of the eighth embodiment, except that in each container-type data center 20, an openable first partition door 205 is opened on two long edges 21 between the first row of the cabinets 201 and the second row of the cabinets 202, an openable second partition door 206 is opened on the two long edges 21 between the third row of the cabinets 203 and the fourth row of the cabinets 204, and an openable third partition door 207 is disposed on a long edge 21 between the second row of the cabinets 202 and the third row of the cabinets 203, so that the maintainer may enter the air outlet channel to perform device maintenance through the partition doors (205, 206, and 207).

In practice, the partition doors on the outside long edge of the container may be closed, and the partition doors between the two container-type data centers 20 are opened or closed, so that the air inlet channels are isolated from the air outlet channels in the container through a simple structure.

It can be understood that the partition doors between the two container-type data centers 20 may be removable. After the partition door on the outside long edge of the container is closed, a through channel exists between the two container-type data centers 20, so that the air inlet channels are isolated from the air outlet channels in the container.

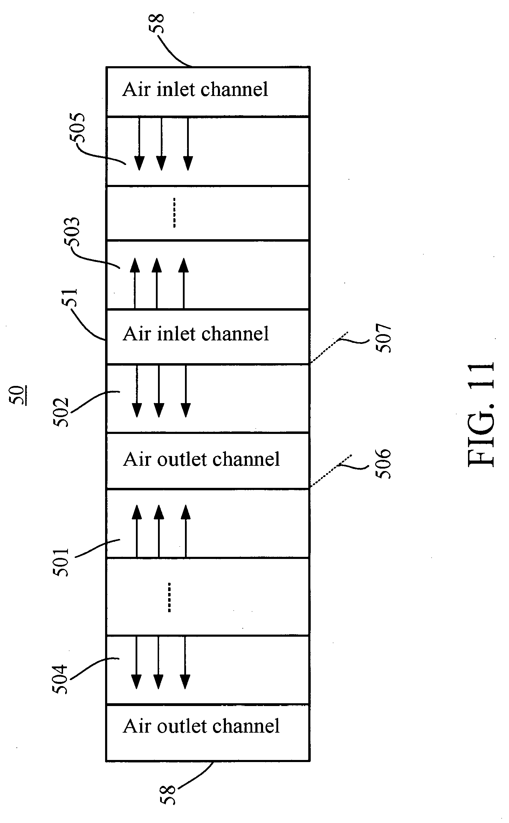

FIG. 11 is a schematic top structural view of a container-type data center according to a third embodiment of the present invention. The container-type data center includes a container, data processing modules, and at least three rows of cabinets. The data processing modules are disposed in the cabinets, the at least three rows of the cabinets are disposed in parallel and perpendicular to a long edge 51 of the container, and two rows of the at least three rows of the cabinets are back-to-back disposed or face-to-face disposed. Side walls at two end portions of each row of the cabinets in the at least three rows of the cabinets are near two long edges of the container, an air inlet channel or an air outlet channel isolated from the air inlet channel is formed from the space between each two rows of the cabinets or between a row of the cabinets and one long edge of the containers; and an openable/removable partition door is disposed on one or two long edges of the container that form each air inlet channel or air outlet channel. As shown in FIG. 11, the at least three rows of the cabinets include a first row of the cabinets 501, a second row of the cabinets 502, and a third row of the cabinets 503. The first row of the cabinets 501 and the second row of the cabinets 502 are back-to-back disposed, and the third row of the cabinets 503 and the second row of the cabinets 502 are face-to-face disposed. An air outlet channel is formed from the space between the first row of the cabinets 501 and the second row of the cabinets 502, an air inlet channel is formed from the space between the third row of the cabinets 503 and the second row of the cabinets 502, and the air outlet channel or the air inlet channel is formed from similar space between the other two cabinets. The air inlet channels are isolated from the air outlet channels in the container.

Specifically, the air inlet channels are isolated from the air outlet channels in the container by disposing the openable partition door between each row of the cabinets that form each air inlet channel or air outlet channel, for example, a first partition door 506 is disposed between the first row of the cabinets 501 and the second row of the cabinets 502, so as to isolate the air outlet channel from the outside, where the air outlet channel is formed from the space between the first row of the cabinets 501 and the second row of the cabinets 502; and a second partition door 507 is disposed between the second row of the cabinets 502 and the third row of the cabinets 503, so as to isolate the air inlet channel from the outside, where the air inlet channel is formed from the space between the second row of the cabinets 502 and the third row of the cabinets 503. Similarly, the air outlet channel or the air inlet channel is isolated from the outside by disposing the partition door between each row of the cabinets that form each air outlet channel or air inlet channel, in which the partition door is disposed on one or two long edges of the container.

The container-type data center according to the embodiment of the present invention can be moved through the movable container, and in another embodiment, the container-type data center can be moved through other movable cases. The cabinet in the embodiment of the present invention is a rack with a standard size of 19 inch. It can be understood that in other embodiments, racks with other standard sizes may also be adopted.

The above descriptions are merely preferred embodiments of the present invention, but not intended to limit the present invention. Therefore, the scope of the present invention should fall within the scope of the following claims.

## Claims

1. A container-type data center (20; 50), comprising a container, at least three rows of cabinets (201, 202, 203, 204; 501, 502, 503, 504), and data processing devices, wherein the data processing devices are disposed in the cabinets, the at least three rows of the cabinets are disposed in parallel and perpendicular to a long edge (21; 51) of the container, two neighboring rows of the cabinets of the at least three rows of the cabinets are back-against-back disposed or disposed at intervals, and wherein for each of the two neighboring rows of the cabinets disposed at intervals, a maintenance channel is formed from the space between the two neighboring rows of the cabinets, two ends of the maintenance channel are the long edges of the container, and an openable or removable partition door (205, 206, 207; 506, 507) is opened on the long edge of one end or two ends.

2. The container-type data center according to claim 1, wherein the manner that the two neighboring rows of the cabinets are disposed at intervals comprises face-to-face or back-to-back disposition; a cabinet air passage is front-in and back-out, an air inlet channel is formed from the space between the two neighboring rows of the cabinets being face-to-face disposed, an air outlet channel is formed from the space between the two neighboring rows of the cabinets being back-to-back disposed, and the air inlet channel is isolated from the air outlet channel.

3. The container-type data center according to claim 2, wherein a partition door (205, 206, 207, 214, 216; 506, 507) configured to isolate the air inlet channel or the air outlet channel from the outside is disposed on an end portion of the air outlet channel or the air inlet channel, respectively.

4. The container-type data center according to claim 1, wherein the two neighboring rows of the cabinets being back-against-back disposed are front maintenance cabinets.

5. The container-type data center according to claim 4, wherein the cabinet air passage is down-in and up-out, front-in and front-out, or down-in and down-out.

6. The container-type data center according to claim 1, wherein the container-type data center further comprises a refrigerating unit, disposed on a top portion, a side portion, or a lower portion of the cabinets of each row, or disposed at intervals between the two neighboring rows of the cabinets.

7. The container-type data center according to claim 1, wherein the at least three rows of the cabinets are arranged from one long edge of the container to the other long edge.

8. A container-type data center cluster, assembled by at least two container-type data centers according to claim 7, wherein the maintenance channels of the container-type data centers are butt-jointed.

9. The container-type data center according to claim 2, wherein the at least three rows of the cabinets are arranged from one long edge of the container to the other long edge; two ends of the air inlet channel and the air outlet channel are the long edge of the container, and a further openable or removable partition door is opened on the long edge of one end or two ends.

10. A container-type data center cluster, assembled by at least two container-type data centers according to claim 9, wherein the air outlet channels of the container-type data centers are butt-jointed, and the air inlet channels of the container-type data centers are butt-jointed.

11. A data center container, comprising at least three rows of cabinets (201, 202, 203, 204; 501, 502, 503, 504), configured to install data processing units of a data center, wherein the at least three rows of the cabinets are disposed in parallel and perpendicular to a long edge (21; 51) of the container, the neighboring rows of the cabinets of the at least three rows of the cabinets are back-against-back disposed or disposed at intervals, and wherein for each of the two neighboring rows disposed at intervals, a maintenance channel is formed from the space between the neighboring rows of the cabinets; two ends of the maintenance channel are the long edges of the container, and an openable or removable partition door (205, 206, 207; 506, 507) is opened on the long edge of one end or two ends.

12. The data center container according to claim 11, wherein the manner that the two neighboring rows of the cabinets are disposed at intervals comprises face-to-face or back-to-back disposition; a cabinet air passage is front-in and back-out, an air inlet channel is formed from the space between the two neighboring rows of the cabinets being face-to-face disposed, an air outlet channel is formed from the space between the two neighboring rows of the cabinets being back-to-back disposed, and the air inlet channel is isolated from the air outlet channel.

13. The data center container according to claim 12, wherein a partition door (205, 206, 207, 214, 216; 506, 507) configured to isolate the air inlet channel or the air outlet channel from the outside is disposed on an end portion of the air outlet channel or the air inlet channel, respectively.

14. The data center container according to claim 11, wherein the at least three rows of the cabinets are arranged from one long edge of the container to the other long edge.

## Patentansprüche

1. Datenzentrum (20; 50) vom Behältertyp, das einen Behälter, wenigstens drei Reihen von Schränken (201, 202, 203, 204; 501, 502, 503, 504) und Datenverarbeitungseinheiten umfasst, wobei die Datenverarbeitungseinheiten in den Schränken angeordnet sind, die wenigstens drei Reihen der Schränke parallel und senkrecht zu einer langen Kante (21; 51) des Behälters angeordnet sind, zwei benachbarte Reihen der Schränke der wenigstens drei Reihen der Schränke Rückseite an Rückseite angeordnet sind oder in Abständen angeordnet sind und wobei für jede der zwei benachbarten Reihen der Schränke, die in Abständen angeordnet sind, ein Wartungskanal aus dem Raum zwischen den zwei benachbarten Reihen der Schränke gebildet ist, wobei zwei Enden des Wartungskanals die langen Kanten des Behälters sind, und eine zu öffnende oder zu entfernende Trenntür (205, 206, 207; 506, 507) an der langen Kante von einem Ende oder von zwei Enden geöffnet wird.

2. Datenzentrum von Behältertyp nach Anspruch 1, wobei die Art, in der die zwei benachbarten Reihen der Schränke in Abständen angeordnet sind, eine Vorderseitean-Vorderseite- oder eine Rückseite-an-Rückseite-Anordnung umfasst; ein Schrankluftdurchlass vorne eingehend und hinten ausgehend ist, ein Lufteinlasskanal aus dem Raum zwischen den zwei benachbarten Reihen der Schränke, die Vorderseite an Vorderseite angeordnet sind, gebildet ist, ein Luftauslasskanal aus dem Raum zwischen den zwei benachbarten Reihen der Schränke, die Rückseite an Rückseite angeordnet sind, gebildet ist und der Lufteinlasskanal von dem Luftauslasskanal getrennt ist.

3. Datenzentrum von Behältertyp nach Anspruch 2, wobei eine Trenntür (205, 206, 207, 214, 216; 506, 507), die konfiguriert ist, den Lufteinlasskanal oder den Luftauslasskanal von der Außenseite zu trennen, an einem Endabschnitt des Luftauslasskanals bzw. des Lufteinlasskanals angeordnet ist.

4. Datenzentrum vom Behältertyp nach Anspruch 1, wobei die zwei benachbarten Reihen der Schränke, die Rückseite an Rückseite angeordnet sind, Frontwartungsschränke sind.

5. Datenzentrum vom Behältertyp nach Anspruch 4, wobei der Schrankluftdurchlass mit unterem Einlass und oberem Auslass, vorderem Einlass und vorderem Auslass oder unterem Einlass und unterem Auslass gebildet ist.

6. Datenzentrum vom Behältertyp nach Anspruch 1, wobei das Datenzentrum vom Behältertyp ferner eine Kühleinheit umfasst, die auf einem oberen Abschnitt, einem seitlichen Abschnitt oder einem unteren Abschnitt der Schränke jeder Reihe angeordnet ist oder in Abständen zwischen den zwei benachbarten Reihen der Schränke angeordnet ist.

7. Datenzentrum vom Behältertyp nach Anspruch 1, wobei die wenigstens drei Reihen der Schränke von einer langen Kante des Behälters zu der anderen langen Kante angeordnet sind.

8. Datenzentrumsgruppe vom Behältertyp, die aus wenigstens zwei Datenzentren vom Behältertyp nach Anspruch 7 zusammengesetzt ist, wobei die Wartungskanäle der Datenzentren vom Behältertyp aneinanderstoßend verbunden sind.

9. Datenzentrum vom Behältertyp nach Anspruch 2, wobei die wenigstens drei Reihen der Schränke von einer langen Kante des Behälters zu der anderen langen Kante angeordnet sind; zwei Enden des Lufteinlasskanals und der Luftauslasskanal die lange Kante des Behälters bilden und eine weitere zu öffnende oder zu entfernende Trenntür an der langen Kante von einem oder von zwei Enden geöffnet wird.

10. Datenzentrumsgruppe vom Behältertyp, die aus wenigstens zwei Datenzentren vom Behältertyp nach Anspruch 9 zusammengesetzt ist, wobei die Luftauslasskanäle der Datenzentren vom Behältertyp aneinanderstoßend verbunden sind und die Lufteinlasskanäle der Datenzentren vom Behältertyp aneinanderstoßend verbunden sind.

11. Datenzentrumsbehälter, der wenigstens drei Reihen von Schränken (201, 202, 203, 204; 501, 502, 503, 504) umfasst und konfiguriert ist, Datenverarbeitungseinheiten eines Datenzentrums zu installieren, wobei die wenigstens drei Reihen der Schränke parallel und senkrecht zu einer langen Kante (21; 51) des Behälters angeordnet sind, die benachbarten Reihen der Schränke der wenigstens drei Reihen der Schränke Rückseite an Rückseite angeordnet sind oder in Abständen angeordnet sind und wobei für jede der zwei benachbarten Reihen, die in Abständen angeordnet sind, ein Wartungskanal aus dem Raum zwischen den benachbarten Reihen der Schränke gebildet ist; zwei Enden der Wartungskanäle die langen Kanten des Behälters sind, und eine zu öffnende oder zu entfernende Trenntür (205, 206, 207; 506, 507) auf der langen Kante von einem Ende oder von zwei Enden geöffnet wird.

12. Datenzentrumsbehälter nach Anspruch 11, wobei die Art, in der die zwei benachbarten Reihen der Schränke in Abständen angeordnet sind, eine Vorderseitean-Vorderseite- oder eine Rückseite-an-Rückseite-Anordnung umfasst; ein Schrankluftdurchlass vorne eingehend und hinten ausgehend ist, ein Lufteinlasskanal aus dem Raum zwischen den zwei benachbarten Reihen der Schränke, die Vorderseite an Vorderseite angeordnet sind, gebildet ist, ein Luftauslasskanal aus dem Raum zwischen den zwei benachbarten Reihen der Schränke, die Rückseite an Rückseite angeordnet sind, gebildet ist und der Lufteinlasskanal von dem Luftauslasskanal getrennt ist.

13. Datenzentrumsbehälter nach Anspruch 12, wobei eine Trenntür (205, 206, 207, 214, 216; 506, 507), die konfiguriert ist, den Lufteinlasskanal oder den Luftauslasskanal von der Außenseite zu trennen, an einem Endabschnitt des Luftauslasskanals bzw. des Lufteinlasskanals angeordnet ist.

14. Datenzentrumsbehälter nach Anspruch 11, wobei die wenigstens drei Reihen der Schränke von einer langen Kante des Behälters zu der anderen langen Kante geordnet sind.

## Revendications

1. Centre de données (20 ; 50) de type conteneur, comportant un conteneur, au moins trois rangées d'armoires (201, 202, 203, 204 ; 501, 502, 503, 504) et des dispositifs de traitement de données, les dispositifs de traitement de données étant disposés dans les armoires, lesdites au moins trois rangées d'armoires étant disposées en parallèle et perpendiculairement à un grand côté (21 ; 51) du conteneur, deux rangées voisines d'armoires parmi lesdites au moins trois rangées d'armoires étant disposées dos à dos ou disposées à intervalles et, pour chacune des deux rangées voisines d'armoires disposées à intervalles, un couloir d'entretien étant formé à partir de l'espace compris entre les deux rangées voisines d'armoires, deux extrémités du couloir d'entretien étant les grands côtés du conteneur, et une porte (205, 206, 207 ; 506, 507) de séparation pouvant être ouverte ou démontée étant ouverte sur le grand côté d'une extrémité ou des deux extrémités.

2. Centre de données de type conteneur selon la revendication 1, la manière dont les deux rangées voisines d'armoires sont disposées à intervalles constituant une disposition face à face ou dos à dos ; un passage d'air d'armoire étant à entrée par l'avant et sortie par l'arrière, un conduit d'entrée d'air étant formé à partir de l'espace compris entre les deux rangées voisines d'armoires disposées face à face, un conduit de sortie d'air étant formé à partir de l'espace compris entre les deux rangées voisines d'armoires disposées dos à dos et le conduit d'entrée d'air étant isolé du conduit de sortie d'air.

3. Centre de données de type conteneur selon la revendication 2, une porte (205, 206, 207, 214, 216 ; 506, 507) de séparation configurée pour isoler le conduit d'entrée d'air ou le conduit de sortie d'air de l'extérieur étant disposée sur une partie d'extrémité du conduit de sortie d'air ou du conduit d'entrée d'air, respectivement.

4. Centre de données de type conteneur selon la revendication 1, les deux rangées voisines d'armoires disposées dos à dos étant des armoires d'entretien frontal.

5. Centre de données de type conteneur selon la revendication 4, le passage d'air d'armoire étant à entrée par le bas et sortie par le haut, à entrée par l'avant et sortie par l'avant, ou à entrée par le bas et sortie par le bas.

6. Centre de données de type conteneur selon la revendication 1, le centre de données de type conteneur comportant en outre une unité de réfrigération disposée sur une partie supérieure, une partie latérale ou une partie inférieure des armoires de chaque rangée, ou disposée à intervalles entre les deux rangées voisines d'armoires.

7. Centre de données de type conteneur selon la revendication 1, lesdites au moins trois rangées d'armoires étant agencées d'un grand côté du conteneur à l'autre grand côté.

8. Grappe de centres de données de type conteneur, constituée par au moins deux centres de données de type conteneur selon la revendication 7, les couloirs d'entretien des centres de données de type conteneur étant mis bout à bout.

9. Centre de données de type conteneur selon la revendication 2, lesdites au moins trois rangées d'armoires étant agencées d'un grand côté du conteneur à l'autre grand côté ; deux extrémités du conduit d'entrée d'air et du conduit de sortie d'air constituant le grand côté du conteneur et une porte de séparation supplémentaire pouvant être ouverte ou démontée étant ouverte sur le grand côté d'une extrémité ou des deux extrémités.

10. Grappe de centres de données de type conteneur, constituée par au moins deux centres de données de type conteneur selon la revendication 9, les conduits de sortie d'air des centres de données de type conteneur étant mis bout à bout et les conduits d'entrée d'air des centres de données de type conteneur étant mis bout à bout.

11. Conteneur pour centre de données, comportant au moins trois rangées d'armoires (201, 202, 203, 204 ; 501, 502, 503, 504), configurées pour installer des unités de traitement de données d'un centre de données, lesdites au moins trois rangées d'armoires étant disposées en parallèle et perpendiculairement à un grand côté (21 ; 51) du conteneur, les rangées voisines d'armoires parmi lesdites au moins trois rangées d'armoires étant disposées dos à dos ou disposées à intervalles et, pour chacune des deux rangées voisines disposées à intervalles, un couloir d'entretien étant formé à partir de l'espace compris entre les rangées voisines d'armoires ; deux extrémités du couloir d'entretien constituant les grands côtés du conteneur et une porte (205, 206, 207 ; 506, 507) de séparation pouvant être ouverte ou démontée étant ouverte sur le grand côté d'une extrémité ou des deux extrémités.

12. Conteneur pour centre de données selon la revendication 11, la manière dont les deux rangées voisines d'armoires sont disposées à intervalles constituant une disposition face à face ou dos à dos ; un passage d'air d'armoire étant à entrée par l'avant et sortie par l'arrière, un conduit d'entrée d'air étant formé à partir de l'espace compris entre les deux rangées voisines d'armoires disposées face à face, un conduit de sortie d'air étant formé à partir de l'espace compris entre les deux rangées voisines d'armoires disposées dos à dos et le conduit d'entrée d'air étant isolé du conduit de sortie d'air.

13. Conteneur pour centre de données selon la revendication 12, une porte (205, 206, 207, 214, 216 ; 506, 507) de séparation configurée pour isoler le conduit d'entrée d'air ou le conduit de sortie d'air de l'extérieur étant disposée sur une partie d'extrémité du conduit de sortie d'air ou du conduit d'entrée d'air, respectivement.

14. Conteneur pour centre de données selon la revendication 11, lesdites au moins trois rangées d'armoires étant agencées d'un grand côté du conteneur à l'autre grand côté.
